# FASCICULE DE BREVET EUROPEEN

(11) **EP 3 447 930 B1**
(45) Date de publication et mention de la délivrance du brevet: **09.10.2019**
(21) Numéro de dépôt: 18188094.9
(22) Date de dépôt: 08.08.2018
(51) Int. Cl.: H04B 5/00

(54) **AJUSTEMENT EN FRÉQUENCE D'UN CIRCUIT NFC**
FREQUENZANPASSUNG EINES NFC-SCHALTKREISES
FREQUENCY ADJUSTMENT OF AN NFC CIRCUIT

(30) Priorité: 25.08.2017 FR 1757883
(43) Date de publication de la demande: 27.02.2019
(73) Titulaire: STMICROELECTRONICS (ROUSSET) SAS, 13790 Rousset (FR)
(72) Inventeur: TRAMONI, Alexandre, 83330 LE BEAUSSET (FR)
(74) Mandataire: Cabinet Beaumont

(56) Documents cités:
- WO-A1-2011/079599
- AU-A1- 2007 214 347
- US-A1- 2014 227 978

## Description

### Domaine

La présente description concerne de façon générale les circuits électroniques et, plus particulièrement, les transpondeurs électromagnétiques ou étiquettes électroniques (TAG). La présente description s'applique plus particulièrement aux dispositifs électroniques intégrant un circuit de communication en champ proche (NFC - Near Field Communication) et à l'ajustement en fréquence du circuit oscillant de tels dispositifs.

### État de l'art antérieur

Les systèmes de communication à transpondeurs électromagnétiques sont de plus en plus fréquents, en particulier, depuis le développement des technologies de communication en champs proche (NFC - Near Field Communication).

Ces systèmes exploitent un champ électromagnétique radiofréquence par un dispositif (terminal ou lecteur) pour communiquer avec un autre dispositif (carte).

Afin d'optimiser la qualité de la communication, la fréquence de résonance d'un circuit oscillant du dispositif captant un champ est généralement ajustée grâce à des éléments capacitifs de valeur réglable.

Dans les systèmes récents, un même dispositif NFC peut opérer en mode carte ou en mode lecteur (par exemple dans le cas d'une communication en champ proche entre deux téléphones mobiles). Il est alors fréquent que les dispositifs soient alimentés par batteries et que leurs fonctions et circuits soient mis en veille pour ne pas consommer d'énergie entre des périodes d'utilisation.

Les dispositifs doivent alors être « réveillés » quand ils se trouvent à portée l'un de l'autre. La détection de champ doit néanmoins opérer en mode veille.

Le document US-A-2014/227978 décrit un circuit de communication comprenant un circuit intégré RF et un élément de capacité variable.

Le document WO-A-2011/079599 décrit un circuit d'adaptation d'antenne et un procédé pour permettre une communication NFC.

Le document AU-A-2007/214347 décrit un circuit pour un système d'accord d'une antenne utilisant une mémoire non-volatile et un circuit de démarrage dans des systèmes RFID passifs.

### Résumé

Un mode de réalisation vise à réduire tout ou partie des inconvénients des techniques connues d'ajustement de la fréquence de résonance d'un circuit oscillant d'un dispositif NFC.

Un mode de réalisation vise à proposer une solution plus particulièrement adaptée à un fonctionnement en mode veille.

Ainsi, un mode de réalisation prévoit un circuit de communication en champ proche comportant un circuit oscillant dont une capacité commandable est commandée par des éléments du circuit, alimentés par une batterie quand le circuit est en veille.

Selon un mode de réalisation, le circuit comporte un pont diviseur résistif commandable alimenté par la batterie et dont une sortie commande la capacité commandable.

Selon un mode de réalisation, la capacité est commandée à partir d'une information mémorisée représentative de l'accord en fréquence du circuit oscillant à partir d'une mesure effectuée avant que le circuit soit mis en veille.

Selon un mode de réalisation, le pont est commandé en fonction de ladite information.

Selon un mode de réalisation, le pont résistif est commandé par un circuit de bascules alimenté par la batterie.

Selon un mode de réalisation, ladite information est stockée dans un registre dont les états des bits conditionnent les états fournis par la bascule.

Selon un mode de réalisation, ladite information est obtenue à partir d'une analyse de l'amplitude et de la phase du signal aux bornes du circuit oscillant.

Selon un mode de réalisation, le pont comporte :
une première résistance connectée entre une première borne d'application d'une tension fournie par la batterie et une borne de sortie connectée à une borne de commande de la capacité commandable ; et
des deuxièmes résistances chacune en série avec un commutateur entre ladite borne de sortie et une deuxième borne d'application de la tension fournie par la batterie.

Un mode de réalisation concerne un procédé de commande d'une capacité commandable d'un circuit oscillant d'un circuit de communication en champ proche, dans lequel la capacité est commandée pendant des périodes de veille du circuit de communication en champ proche en fonction d'une information mesurée avant que le circuit soit en veille.

Un mode de réalisation prévoit un dispositif mobile de communication comportant un circuit de communication en champ proche.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une représentation très schématique et sous forme de blocs d'un exemple de système à communication en champ proche du type auquel s'applique, à titre d'exemple, des modes de réalisation qui vont être décrits ;
la figure 2 est un schéma illustrant partiellement un mode de réalisation de circuits d'un dispositif de communication en champ proche ; et
la figure 3 représente, de façon très schématique un mode de réalisation d'une interface NFC.

### Description détaillée

De mêmes éléments ont été désignés par de mêmes références aux différentes figures.

Par souci de clarté, seules les étapes et éléments utiles à la compréhension des modes de réalisation qui vont être décrits ont été représentés et seront détaillés. En particulier, la génération des signaux radiofréquences et leur interprétation n'ont pas été détaillées, les modes de réalisation décrits étant compatibles avec les techniques usuelles de génération et d'interprétation de ces signaux.

Sauf précision contraire, lorsque l'on fait référence à deux éléments connectés entre eux, cela signifie directement connectés sans élément intermédiaire autre que des conducteurs, et lorsque l'on fait référence à deux éléments reliés entre eux, cela signifie que ces deux éléments peuvent être directement reliés (connectés) ou reliés par l'intermédiaire d'un ou plusieurs autres éléments.

Dans la description qui suit, lorsqu'on fait référence aux termes « approximativement », « environ » et « de l'ordre de », cela signifie à 10 % près, de préférence à 5 % près.

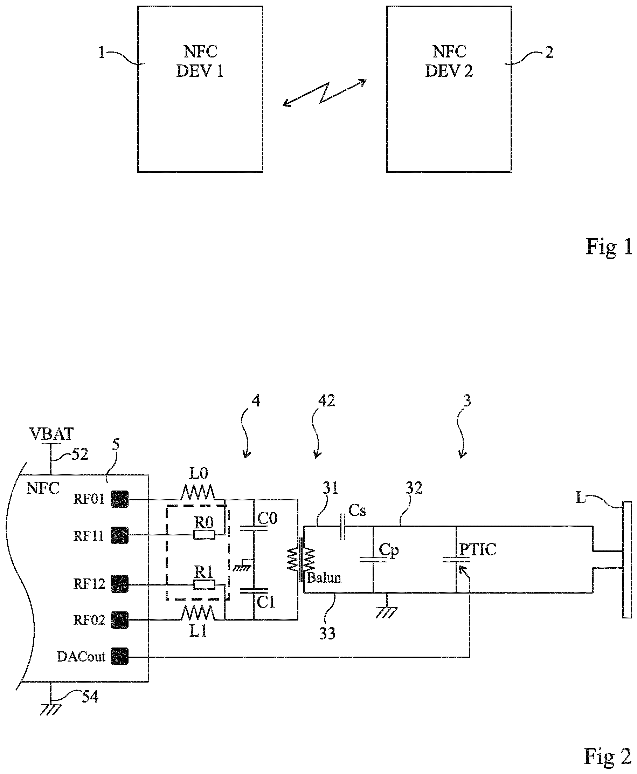

La figure 1 est une représentation très schématique et sous forme de blocs d'un exemple de système de communication en champ proche du type auquel s'appliquent, à titre d'exemple, des modes de réalisation qui vont être décrits.

On suppose le cas de deux dispositifs électroniques similaires, par exemple deux téléphones mobiles, mais tout ce qui va être décrit s'applique plus généralement à tout système dans lequel un transpondeur capte un champ électromagnétique rayonné par un lecteur, borne ou terminal. Pour simplifier, on fera référence à des dispositifs NFC pour designer des dispositifs électroniques intégrant des circuits de communication en champ proche.

Deux dispositifs NFC 1 (NFC DEV1) et 2 (NFC DEV2) sont susceptibles de communiquer par couplage électromagnétique en champ proche. Selon les applications, pour une communication, un des dispositifs fonctionne en mode dit lecteur tandis que l'autre fonctionne en mode dit carte, ou les deux dispositifs communiquent en mode poste à poste (peer to peer - P2P). Chaque dispositif comporte divers circuits électroniques, parmi lesquels un circuit constituant une interface de communication en champ proche, ou interface NFC, entre le dispositif NFC et l'extérieur. Cette interface sert entre autres, en mode lecteur, à générer un signal radiofréquence émis à l'aide d'une antenne et, en mode carte, à décoder un signal radiofréquence capté. Le champ radiofréquence généré par l'un des dispositifs est capté par l'autre dispositif qui se trouve à portée et qui comporte également une antenne.

Les interfaces NFC comportent des circuits oscillants qui sont généralement équipés de capacités variables afin d'améliorer la communication en corrigeant d'éventuelles dérives de la fréquence de résonance normalisée (typiquement 13,56 MHz). La capacité qui équipe ce circuit oscillant est généralement une capacité dont le réglage de la valeur est commandé en tension. Il peut s'agir d'un réseau de capacités commutables en parallèle ou d'une capacité intégrée commandable PTIC (Programmable Integrated Capacitor). La commande provient d'un circuit NFC de l'interface et est généralement analogique en utilisant un convertisseur numérique-analogique. Le circuit NFC mesure l'amplitude et la phase aux bornes du circuit oscillant. Un microcontrôleur intégré au circuit NFC en déduit la fréquence d'accord du circuit oscillant et génère une commande numérique, convertie par un convertisseur numérique-analogique, pour appliquer un signal analogique sur la borne de commande de la capacité PTIC.

La figure 2 est un schéma illustrant partiellement un mode de réalisation de circuits d'un dispositif de communication en champ proche.

De façon simplifiée, une interface NFC comporte au moins un circuit résonant 3, série et/ou parallèle. Dans l'exemple de la figure 2, le circuit 3 comporte une inductance L formant antenne et un circuit capacitif. Ce circuit capacitif comporte un premier condensateur Cs connecté en série avec l'antenne L entre des bornes 31 et 33 d'entrée-sortie du circuit résonant 3, un deuxième condensateur Cp connecté en parallèle avec l'antenne L entre une borne 32 de connexion du condensateur Cs à l'antenne L et la borne 33, et une capacité réglable PTIC commandée en tension en parallèle avec le condensateur Cp. Le cas échéant, la capacité PTIC remplace le condensateur Cp.

Dans l'exemple représenté, le même circuit résonant 3 sert en émission et en réception. Dans ce cas, les bornes 31 et 33 sont reliées à des bornes d'entrée RFI1 et RFI2 d'une chaine de réception radiofréquence d'un circuit NFC 5 et à des bornes de sortie RFO1 et RFO2 d'une chaine d'émission radiofréquence du circuit 5, par l'intermédiaire de divers circuits 4 (adaptateurs d'impédance, aiguilleurs, coupleurs, transformateur à changement de mode ou balun, etc.). Par exemple, chaque borne RFO1, RFO2 est reliée, par un filtre LC, à l'une des bornes d'un premier enroulement d'un transformateur à changement de mode 42 (Balun) dont les bornes d'un deuxième enroulement sont connectées aux bornes 31 et 33. Chaque filtre LC comporte une inductance L0, respectivement L1, entre la borne RFO1, respectivement RFO2, et le balun 42, ainsi qu'un condensateur C0, respectivement C1, entre le balun et la masse. Dans l'exemple de la figure 2, chaque borne RFI1, RFI2 est reliée au balun par une résistance, respectivement R0 ou R1, pour former en réception un filtre RC avec le condensateur C0 ou C1.

La capacité PTIC est commandée par un signal (une tension) analogique fournie par le circuit 5 (borne DACout) qui est fonction d'une évaluation du couplage, par exemple par analyse de l'amplitude et de la phase du signal aux bornes de l'antenne.

Le cas échéant, le dispositif comporte deux antennes respectivement d'émission et de réception. Chaque chaîne de transmission (émission ou réception) comporte alors les éléments requis entre l'antenne et le circuit 5 ou son équivalent.

Le circuit 5 comporte bien entendu d'autres bornes parmi lesquelles des bornes 52 et 54 de raccordement à une batterie (tension VBAT) du dispositif NFC en particulier pour un fonctionnement en mode lecteur, des bornes de raccordement à des bus de communication (données, adresses, commandes) internes au dispositif NFC, etc.

Le fonctionnement d'une interface NFC telle que représentée en figure 2 est usuel.

Les circuits de l'interface NFC (notamment le circuit 5) sont généralement déconnectés de la batterie pendant les périodes où le dispositif NFC est en veille. Par ailleurs, lorsqu'il fonctionne en mode carte, le circuit 5 peut extraire l'alimentation requise pour son fonctionnement du champ électromagnétique dans lequel il se trouve. En pratique, dans les applications visées par la présente description, lorsqu'un dispositif NFC n'est pas en cours de communication, il est commuté en mode veille afin de réduire l'énergie consommée. Dans ce cas, le réglage de la fréquence d'accord par le circuit 5 ne peut pas s'opérer et le circuit 5 risque de ne pas être réveillé en présence d'un champ.

En effet, comme la commande de la capacité PTIC est effectuée par le circuit NFC, lorsque celui-ci est en veille et est censé être alimenté par le champ capté par le circuit oscillant, le réglage ne s'opère qu'une fois le circuit réveillé. Cela remplit l'objectif pendant la communication. Toutefois, hors communication, il serait souhaitable de continuer à ajuster la fréquence d'accord du circuit oscillant qui peut varier, de façon non négligeable, en fonction des conditions environnementales (objet à proximité, main de l'utilisateur, etc.). Cela n'est pas compatible avec un mode basse consommation dans la mesure où cela exigerait de laisser allumés le microcontrôleur, le convertisseur numérique-analogique, etc.

Ainsi, une difficulté réside dans le fait que l'énergie récupérée afin de réveiller un dispositif NFC dépend du couplage opéré avec le dispositif émetteur. Le facteur de couplage dépend de plusieurs paramètres parmi lesquels la distance entre les deux dispositifs, mais également d'un désaccord entre les deux interfaces NFC (leurs circuits oscillants). Typiquement, la fréquence d'accord d'interfaces NFC est de 13,56 MHz. Cependant, si l'une des interfaces est désaccordée, l'énergie qu'elle extrait du champ rayonné par l'autre dispositif NFC peut être trop faible pour qu'elle soit réveillée.

Selon les modes de réalisation décrits, on prévoit de mémoriser une information représentative d'une valeur d'adaptation de l'accord du circuit oscillant 3 du dispositif, avant de le mettre en veille, et d'utiliser cette information pendant que le dispositif est en veille afin qu'il puisse détecter un champ éventuel et être réveillé (sortir du mode veille).

Toujours selon les modes de réalisation décrits, les circuits requis pour l'adaptation de l'accord sont alimentés, au moins pendant les périodes de veille, par la batterie du dispositif. Ainsi, pendant les périodes de veille, l'accord peut être adapté. De plus, il n'est pas nécessaire d'effectuer de mesure et les circuits correspondant peuvent être désactivés. Au lieu d'être alimenté, comme dans les dispositifs NFC usuels, par l'énergie extraite du champ une fois que le circuit NFC est « réveillé » par le champ capté, le réseau résistif est, au moins quand le circuit est en veille, alimenté par la batterie.

Selon les modes de réalisation décrits, on prévoit d'effectuer, au moins pendant les périodes de veille, cet accord en fréquence à l'aide d'un réseau résistif monté en pont diviseur de tension et dont la sortie est connectée à la borne de commande de l'élément capacitif variable du circuit oscillant. La commande du réseau résistif est effectuée à partir d'un circuit de commande simplifié, intégré à l'interface NFC, mais qui est distinct de son microcontrôleur.

Ainsi, pendant les périodes de veille, on prévoit de conserver l'accord sans convertisseur numérique-analogique, ni microcontrôleur afin d'engendrer une consommation suffisamment faible pour être compatible avec un mode de fonctionnement en veille, alimenté par la batterie du dispositif NFC.

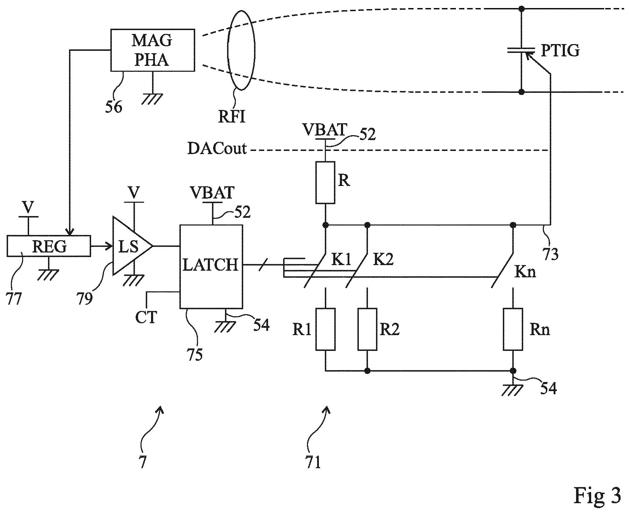

La figure 3 représente un mode de réalisation d'une interface NFC équipée d'un circuit 7 de commande simplifié.

Pour simplifier, seuls ont été représentés la capacité variable PTIC du circuit oscillant et le circuit de commande 7, et les autres circuits de l'interface NFC sont similaires à ceux décrits en relation avec la figure 2. En particulier, l'interface comporte un microcontrôleur, les divers circuits 4, etc.

Selon le mode de réalisation de la figure 3, le circuit 7 comporte un pont diviseur résistif multiple 71, entre les bornes 52 et 54 d'application de la tension VBAT comportant, par exemple, une résistance R entre la borne 52 et une borne 73 de sortie du pont, connectée à la borne de commande de la capacité PTIC, et n résistances R1, R2, ..., Rn, respectivement en série avec n commutateurs K1, K2, ..., Kn, entre la borne 73 et la masse 54. Les n commutateurs K sont commandés individuellement par un circuit 75 de bascules (LATCH), alimenté par la tension VBAT. Les bascules 75 sont, par exemple, de type RS et reçoivent sur leurs entrées de mise à un, des bits d'un mot d'un registre 77 (REG) . Le cas échéant, un circuit décaleur de niveau 79 (LS) est intercalé entre la sortie du registre et le circuit 75. Les entrées de réinitialisation des bascules reçoivent un signal CT indicateur d'un état de veille (ou de non-veille) de l'interface.

De préférence, hors des périodes de veille (signal CT inactif), tous les interrupteurs K sont ouverts et la capacité PTIC n'est pas commandée par le pont résistif 71. De préférence, on utilise les circuits usuels tels que les circuits de mesure et le convertisseur numérique-analogique fournissant un signal analogique sur la borne DACout (figure 2). Quand le signal CT est actif, les interrupteurs K sont commandés en fonction des bits du registre 77 afin de mettre plus ou moins de résistances R en parallèle. Dans une réalisation où le circuit 7 est intégré au circuit 5 de la figure 2, on peut considérer que la sortie DACout fournit la sortie du convertisseur analogique-numérique alimenté hors des périodes de veille et la sortie 73 du pont résistif pendant les périodes de veille.

Le contenu du registre 77 est mis à jour, de préférence avant chaque mise en veille, à partir d'une analyse, par un circuit 56 (MAG PHA), de l'amplitude et de la phase du signal présent sur les bornes RFI. Ce circuit 56 est, en lui-même, usuel et correspond, par exemple, à celui utilisé par le convertisseur numérique-analogique. On suppose pour cela que le circuit est destiné à être mis en veille à chaque fin de communication.

En variante, le registre 77 est mis à jour périodiquement, de préférence à chaque mesure effectuée par le circuit 56 hors des périodes de veille. Selon une autre variante, le registre sert de registre d'entrée au convertisseur numérique-analogique.

Le registre 77, son circuit de lecture (non représenté) et le circuit 79 sont alimentés par une tension V qui, en période de veille correspond à la tension VBAT et qui, hors des périodes de veille, n'est pas modifiée par rapport à une interface NFC usuelle, c'est-à-dire correspond à la tension VBAT en mode lecteur et à la tension extraite du champ capté en mode carte.

Le circuit 56 peut rester alimenté par l'énergie prélevée sur le champ capté, car il ne sert pas en mode veille.

Hormis les circuits mentionnés ci-dessus, les autres circuits de l'interface NFC ne sont, de préférence, pas modifiés. En particulier, l'interface comporte toujours un convertisseur numérique-analogique fournissant un signal de consigne au condensateur PTIC quand l'interface est active (hors des périodes de veille). Le cas échéant, ce convertisseur réutilise le registre 77 et le circuit 79.

Un avantage des modes de réalisation décrits est qu'ils permettent d'ajuster l'accord du circuit résonant de l'interface NFC y compris pendant les périodes de veille.

Un autre avantage des modes de réalisation décrits est qu'ils permettent de disposer, dans les périodes de veille, d'un réglage de l'accord correspondant au dernier accord mesuré, ce qui améliore la détection du champ.

Un autre avantage des modes de réalisation décrits est qu'ils ne modifient pas les protocoles de communication entre les dispositifs.

Divers modes de réalisation ont été décrits. Diverses modifications apparaîtront à l'homme de l'art. En particulier, le choix du nombre d'interrupteurs K et de la taille du registre 77 peut varier d'une application à une autre. En outre, la mise en oeuvre pratique des modes de réalisation qui ont été décrits est à la portée de l'homme du métier en utilisant les indications fonctionnelles données ci-dessus.

## Revendications

1. Circuit de communication en champ proche comportant un circuit oscillant (3) dont une capacité commandable (PTIC) est commandée par des éléments du circuit, quand le circuit est en veille, lesdits éléments étant alors alimentés par une batterie.

2. Circuit selon la revendication 1, comportant un pont diviseur résistif commandable (71) alimenté par la batterie et dont une sortie commande la capacité commandable (PTIC).

3. Circuit selon la revendication 1 ou 2, dans lequel la capacité (PTIC) est commandée à partir d'une information mémorisée représentative de l'accord en fréquence du circuit oscillant à partir d'une mesure effectuée avant que le circuit soit mis en veille.

4. Circuit selon la revendication 3, dans lequel le pont (71) est commandé en fonction de ladite information.

5. Circuit selon l'une quelconque des revendications 2 à 4, dans lequel le pont résistif (71) est commandé par un circuit de bascules (75) alimenté par la batterie.

6. Circuit selon la revendication 5, dans lequel ladite information est stockée dans un registre (77) dont les états des bits conditionnent les états fournis par la bascule (75) .

7. Circuit selon l'une quelconque des revendications 3 à 6, dans lequel ladite information est obtenue à partir d'une analyse de l'amplitude et de la phase du signal aux bornes du circuit oscillant (3).

8. Circuit selon l'une quelconque des revendications 3 à 7, dans lequel le pont (71) comporte :
une première résistance (R) connectée entre une première borne (52) d'application d'une tension (VBAT) fournie par la batterie et une borne de sortie (73) connectée à une borne de commande de la capacité commandable (PTIC) ; et
des deuxièmes résistances (R1, R2, ..., Rn) chacune en série avec un commutateur (K1, K2, ..., Kn) entre ladite borne de sortie et une deuxième borne d'application de la tension fournie par la batterie.

9. Procédé de commande d'une capacité commandable (PTIC) d'un circuit oscillant (3) d'un circuit de communication en champ proche, dans lequel la capacité est commandée pendant des périodes de veille du circuit de communication en champ proche en fonction d'une information mesurée avant que le circuit soit en veille.

10. Dispositif mobile de communication comportant un circuit selon l'une quelconque des revendications 1 à 8.

## Patentansprüche

1. Nahfeldkommunikationsschaltung, aufweisend einen Schwingkreis (3) mit einem steuerbaren Kondensator (PTIC), der durch Schaltungselemente gesteuert wird, wenn sich die Schaltung im Standby-Modus befindet, wobei die Elemente von einer Batterie mit Leistung versorgt werden.

2. Die Schaltung nach Anspruch 1, aufweisend eine steuerbare Widerstands-Teilerbrücke (71), die von der Batterie mit Leistung versorgt wird und einen Ausgang aufweist, der den steuerbaren Kondensator (PTIC) steuert.

3. Schaltung nach Anspruch 1 oder 2, wobei der Kondensator (PTIC) basierend auf gespeicherten Daten gesteuert wird, die repräsentativ sind für die Frequenzabstimmung des Schwingkreises basierend auf einer Messung, die durchgeführt wird, bevor die Schaltung in den Standby-Modus versetzt wird.

4. Die Schaltung nach Anspruch 3, wobei die Brücke (71) gemäß den Daten gesteuert wird.

5. Schaltung nach einem der Ansprüche 2 bis 4, wobei die Widerstandsbrücke (71) durch eine von der Batterie mit Leistung versorgte Latch-Schaltung (75) gesteuert wird.

6. Die Schaltung nach Anspruch 5, wobei die Daten in einem Register (77) gespeichert sind, wobei die Zustände seiner Bits die von dem Latch (75) gelieferten Zustände konditionieren.

7. Schaltung nach einem der Ansprüche 3 bis 6, wobei die Daten aus einer Analyse der Amplitude und der Phase des Signals über den Schwingkreis (3) erhalten werden.

8. Schaltung nach einem der Ansprüche 3 bis 7, wobei die Brücke (71) Folgendes aufweist:
einen ersten Widerstand (R), der verbunden ist zwischen einem ersten Anschluss (52) zum Anlegen einer von der Batterie gelieferten Spannung (VBAT) und einem Ausgangsanschluss (73), der mit einem Steueranschluss des steuerbaren Kondensators (PTIC) verbunden ist; und
zweite Widerstände (R1, R2, ...., Rn), die jeweils in Reihe geschaltet sind mit einem Schalter (K1, K2, ...., Kn) zwischen dem Ausgangsanschluss und einem zweiten Anschluss zum Anlegen der von der Batterie gelieferten Spannung.

9. Verfahren zum Steuern eines steuerbaren Kondensators (PTIC) eines Schwingkreises (3) einer Nahfeldkommunikationsschaltung, wobei der Kondensator während Standby-Perioden der Nahfeldkommunikationsschaltung anhand von Daten gesteuert wird, die vor dem Standby-Betrieb der Schaltung gemessenen wurden.

10. Mobile Kommunikationsvorrichtung, die die Schaltung nach einem der Ansprüche 1 bis 8 aufweist.

## Claims

1. A near-field communication circuit comprising an oscillating circuit (3) having a controllable capacitor (PTIC) controlled by circuit elements when the circuit is at standby, said elements being then powered by a battery.

2. The circuit of claim 1, comprising a controllable resistive dividing bridge (71) powered by the battery and having an output controlling the controllable capacitor (PTIC).

3. The circuit of claim 1 or 2, wherein the capacitor (PTIC) is controlled based on stored data representative of the frequency tuning of the oscillating circuit based on a measurement performed before the circuit is set to standby.

4. The circuit of claim 3, wherein the bridge (71) is controlled according to said data.

5. The circuit of any of claims 2 to 4, wherein the resistive bridge (71) is controlled by a latch circuit (75) powered by the battery.

6. The circuit of claim 5, wherein said data are stored in a register (77) having the states of its bits conditioning the states supplied by the latch (75).

7. The circuit of any of claims 3 to 6, wherein said data are obtained from an analysis of the amplitude and of the phase of the signal across the oscillating circuit (3).

8. The circuit of any of claims 3 to 7, wherein the bridge (71) comprises:
a first resistor (R) connected between a first terminal (52) of application of a voltage (VBAT) supplied by the battery and an output terminal (73) connected to a control terminal of the controllable capacitor (PTIC); and
second resistors (R1, R2, ..., Rn), each in series with a switch (K1, K2, ..., Kn) between said output terminal and a second terminal of application of the voltage supplied by the battery.

9. A method of controlling a controllable capacitor (PTIC) of an oscillating circuit (3) of a near-field communication circuit, wherein the capacitor is controlled during standby periods of the near-field communication circuit according to data measured before the circuit is at standby.

10. A mobile communication device comprising the circuit of any of claims 1 to 8.
